Europäisches Patentamt

European Patent Office

Office européen des brevets

(19)

(11) Veröffentlichungsnummer: **0 221 399 B1**

## (12) EUROPÄISCHE PATENTSCHRIFT

(45) Veröffentlichungstag der Patentschrift: **06.03.91**

(51) Int. Cl.5: **H01L 23/528**, H01L 25/16

(21) Anmeldenummer: **86114083.8**

(22) Anmeldetag: **10.10.86**

(54) **Leistungshalbleitermodul.**

(30) Priorität: **02.11.85 DE 3538933**

(43) Veröffentlichungstag der Anmeldung:
**13.05.87 Patentblatt 87/20**

(45) Bekanntmachung des Hinweises auf die
Patenterteilung:
**06.03.91 Patentblatt 91/10**

(84) Benannte Vertragsstaaten:
**DE FR GB IT NL SE**

(56) Entgegenhaltungen:
**EP-A- 0 152 818**
**DE-A- 3 201 296**
**US-A- 4 038 488**

(73) Patentinhaber: **Asea Brown Boveri Aktiengesellschaft**
**Kallstadter Strasse 1**
**W-6800 Mannheim-Käfertal(DE)**

(72) Erfinder: **Gobrecht, Jens, Dr. Dipl.-Ing.**
**Brühlstrasse 37**
**CH-5412 Gebenstorf(CH)**
Erfinder: **Bayerer, Reinhold, Dr. Dipl.-Ing.**
**Forststrasse 27a**
**W-6101 Reichelsheim(DE)**

(74) Vertreter: **Rupprecht, Klaus, Dipl.-Ing. et al**
**c/o Asea Brown Boveri Aktiengesellschaft**
**Zentralbereich Patente Postfach 100351**
**W-6800 Mannheim 1(DE)**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung bezieht sich auf ein Leistungshalbleitermodul nach dem Oberbegriff des Anspruchs 1. Ein derartiges Modul ist aus der DE-OS 3406528

Mit Leistungshalbleitermodulen können Stromrichterschaltungen oder Teile solcher Schaltungen realisiert werden. Dazu werden auf die Bodenplatte die erforderlichen Elemente, z.B. Halbleiterchips, passive Bauelemente und Verbindungselemente aufgelötet. Während des Lötvorganges müssen die zu verlötenden Elemente an den entsprechenden Stellen fixiert werden. Dazu werden üblicherweise Lötformen benutzt, die speziell für das jeweilige Modul hergestellt werden bzw. an das Modul angepaßt sind. Der Aufwand für die Herstellung der Lötform selbst sowie der Aufwand an Material und Arbeitszeit für die Modulherstellung mit Hilfe der Lötform ist von der Modulgestaltung abhängig.

Die DE-OS 34 06 528 enthält einen Vorschlag zur Vereinfachung der Lötform, wobei ein sandwichartiger Aufbau des Moduls vorgeschlagen wird. Dabei sind die Halbleiterbauelemente zwischen einer keramischen Bodenplatte und einer keramischen Deckplatte angeordnet. Zur Fixierung der Bauelemente sind Zentrierstifte und Zentrierhülsen erforderlich, die in die Deckplatte gesteckt werden. Elektrische Verbindungen zwischen Bodenplatte und Deckplatte werden durch Kontaktstempel hergestellt. Insgesamt sind relativ viele Einzelteile zur Herstellung des Moduls erforderlich.

Aus der US-A-4038488 ist ein Halbleitermodul bekannt, bei den ein mehrschichtiges Substrat aus einer keramischen Bodenplatte, darüberliegendeu Keramikplatten, die mit Ausschmitten versehen sind, welche der Aufuahme und Fixierung vou Halbleiterchips dieuen, und jeweils zwischen den Platten befindlichen strukturierten Metallisieruugen besteht.

Ein weiteres Problem besteht bei Leistungshalbleitermodulen darin, daß eine durch das Halbleiterbauelement ermöglichte hohe Schaltgeschwindigkeit durch hohe Streuinduktivität der modulinternen Leitungen vermindert wird.

Der vorliegenden Erfindung liegt die Aufgabe zugrunde, die genannten Nachteile bekannter Leistungshalbleitermodule zu vermeiden.

Diese Aufgabe wird für ein Leistungshalbleitermodul nach dem Oberbegriff des Auspruchs 1 dadurch daß die Keramikplatten und die Metallisierungen in abwechselnder Folge zu einem mehrschichtigen Substrat verbunden sind, in dem die mindestens eine weitere Keramikplatte mit Ausschnitten versehen ist, in die die Leistungshalbleiterchips eingesetzt und dabei wie von einer Lötforn fixiert sind, in dem die Metallisierungen aus einer 0,1 bis 0,5 mm dicken Metallfolie bestehen und derart angeordnet sind, daß sich zwischen der Bodenplatte und der mindestens einen weiteren Keramikplatte eine erste strukturierte Metallisierung und auf der Oberseite der mindestens einen weiteren Keramikplatte eine zweite strukturierte Metallisierung befindet, und in dem die erste und die zweite strukturierte Metallisierung in übereinanderliegenden Streifen derart ausgeführt sind, daß interne Streifenleitungen gebildet sind, deren Wellenwiderstand durch die Streifenbreite und durch ihren der Dicke der mindestens einen weiteren Keramikplatte entsprechenden Abstand bestimmt ist.

Vorteilhafte Ausgestaltungen sind in den Unteransprüchen angegeben.

Der vorgeschlagene Aufbau des Leistungshalbleitermoduls hat eine Reihe von Vorteilen:

- Die mehrschichtige Anordnung des Substrats, das den Modulboden bildet, kann durch direktes Verbinden von 0,1 bis 0,5mm dicken Kupferfolien mit Keramikplatten hergestellt werden. Ein solches Substrat weist eine hohe mechanische Festigkeit auf. Damit kann die erforderliche Ebenheit der Grundfläche mit hoher Genauigkeit erreicht werden und es ist eine hohe Biege- und Bruchfestigkeit gegeben.

- Das beschriebene Substrat ist hochtemperaturfest bis etwa 1000°C. Deshalb können Halbleiterelemente und Anschlußelemente bei hohen Temperaturen, z.B. 400°C unter Wasserstoffatmosphäre aufgelötet werden. Die Haftfertigkeit der Metallisierung auf der Keramik bleibt dabei erhalten.

- Die dicken Kupfer-Leiterbahnen sorgen für eine gute zusätzliche Querableitung der Wärmeverlustleistung von Leistungshalbleitern. Solche Bauelemente lassen sich deshalb auch in höheren isolierten Ebenen, z.B. einer 2. oder 3. Ebene unter Einhaltung geringer Wärmewiderstände montieren.

- Der Aufbau des Substrats ermöglicht eine bandförmige Stromführung im Substrat, wodurch die Streuinduktivität gering ist.

- Das Substrat ist durch die Keramische Bodenplatte gegen eine Bodenmetallisierung bzw. gegen einen Kühlkörper elektrisch isoliert. Die Isolationsspannung kann dabei typisch $2,5 kV_{eff}$ betragen. Diese Isolationsspannung ist auch erreichbar zwischen getrennten Leiterbahnen auf einer Schicht oder zwischen Leiterbahnen, die sich auf verschiedenen Schichten befinden. Die erforderliche Kriech- und Luftstrecken zwischen der Kühlfläche und den nach oben geführten Anschlüssen werden eingehalten, auch wenn die Außenanschlüsse und das Substrat eine Bandleitungsstruktur aufweisen.

- Die keramische Ausdehnung des Substrats ist an Silizium angepaßt und führt zu einer hohen Lastwechselfestigkeit der Lötverbindungen.

Ein Ausführungsbeispiel der Erfinduug wind anhand der Zeichnung erläutert.

Es zeigen:

Fig. 1    Schnitt durch ein Leistungshalbleitermodul,

Fig. 2    Draufsicht auf das Leistungshalbleitermodul,

Fig. 3    elektrische Schaltung des Leistungshalbleitermoduls.

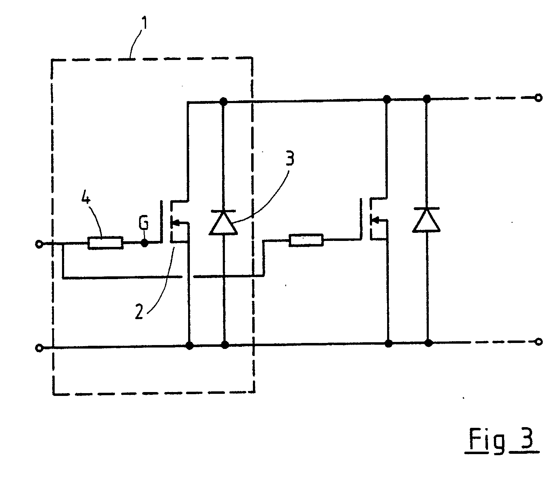

Fig. 3 zeigt eine Halbleiterschaltung, wobei ein mit gestrichelter Linie umrandeter Schaltungsteil 1 hervorgehoben ist. Der Schaltungsteil 1 umfaßt einen Leistungstransistor 2 mit einer parallel geschalteten Diode 3 und einem Widerstand 4 vor dem Gate G des Leistungstransistors 2. Bei dem Leistungstransistor 2 handelt es sich um einen Power (vertikal)-MOSFET und bei der Diode 3 um eine Schottky-Freilaufdiode. In einem Leistungshalbleitermodul können mehrere solcher Schaltungsteile 1 realisiert und zum Beispiel parallelgeschaltet sein.

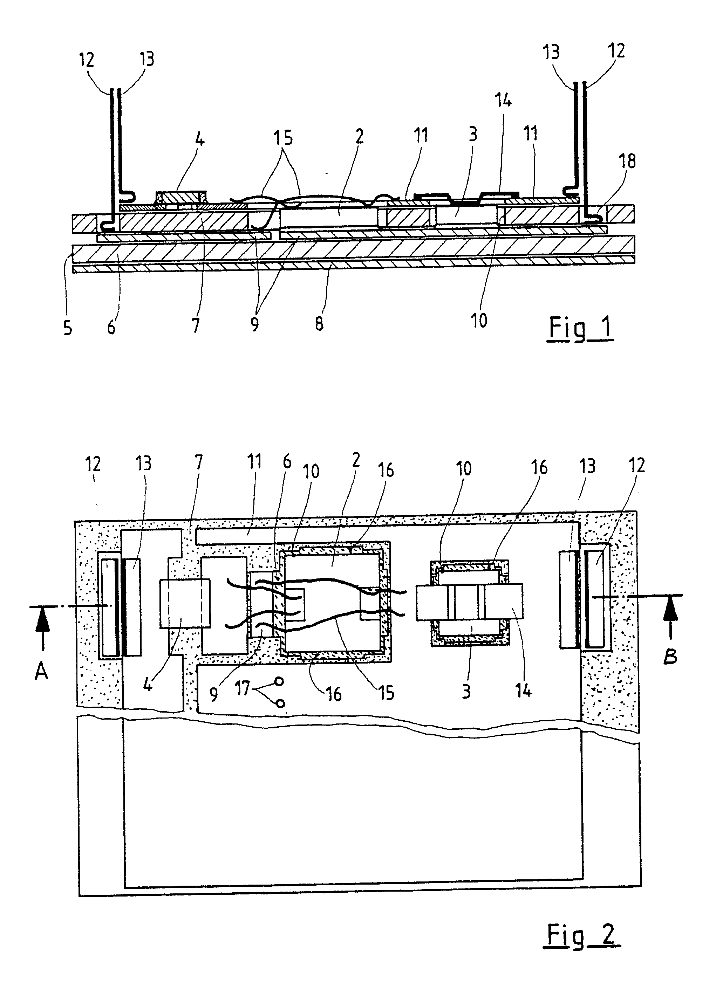

Fig. 1 zeigt einen Schnitt durch eine in Fig. 2 eingetragene Schnittebene A-B, wobei ein Schnitt durch den in Fig. 3 hervorgehobenen Schaltungsteil 1 gezeigt wird.

In Fig. 1 ist ein Substrat 5 dargestellt, das zwei keramische Platten 6, 7 enthält. Mit 6 ist eine keramische Bodenplatte bezeichnet, die auf der unteren, einem nicht dargestellten Kühlkörper zugewandten Seite eine ganzflächige Metallisierung 8 trägt und auf der Oberseite eine strukturierte Metallisierung 9. Auf der strukturierten Metallisierung 9 ist mindestens eine weitere Keramikplatte 7 angeordnet. Diese zweite Keramikplatte 7 ist mit Ausschnitten 10 zur Aufnahme der Halbleiterbauelemente 2, 3 versehen und trägt auf der Oberseite eine zweite strukturierte Metallisierung 11. Alle Metallisierungen 8, 9, 11 bestehen aus einer Kupferfolie, die 0,1 bis 0,5mm dick ist. Die Schichten des Substrats 5, nämlich die ganzflächige Metallisierung 8, die Bodenplatte 6, die strukturierte Metallisierung 9, die zweite Keramikplatte 7 und die zweite strukturierte Metallisierung 11 und evtl. weitere Keramik- und Metallschichten werden in einem Arbeitsgang durch direktes Verbinden (Directbonding) miteinander verbunden. Ein solches Verbindungsverfahren ist z.B. in der DE-OS 30 36 128 beschrieben.

In die Ausschnitte 10 der zweiten Keramikplatte 7 werden die vorbeloteten Halbleiterbauelemente 2, 3 sowie Anschlußelemente 12 eingesetzt, die mit der strukturierten Metallisierung 9 zu kontaktieren sind. Anschlußelemente 13, die mit der zweiten strukturierten Metallisierung 11 zu kontaktieren sind, sowie der Widerstand 4 und ein Clip 14 können mit einer nicht dargestellten dritten Keramikplatte, die mit entsprechenden Ausschnitten versehen und auf die Metallisierung 11 der zweiten Keramikplatte 7 aufgebracht ist, oder mit anderen Mitteln fixiert werden. Sämtliche Lötverbindungen werden zugleich in einem Arbeitsgang hergestellt. Anschließend werden weitere interne Verbindungen durch Bonden von Aluminiumdrähten 15 hergestellt.

Die Bodenplatte 6 dient zur Isolierung gegenüber dem Kühlkörper und sie sorgt für einen geringen Wärmewiderstand bei der Wärmeableitung von den Halbleiterbauelementen 2, 3 zum Kühlkörper. Die zweite Keramikplatte 7 sowie evtl. weitere darüber angeordnete Keramikplatten sind als sogenannte verlorene Lötformen anzusehen, da sie Bestandteil des Moduls sind. Allerdings sind sie nicht nur als verlorene Lötformen anzusehen, weil der mehrschichtige Aufbau des Substrats 5 zusätzlich eine hohe mechanische Festigkeit des Moduls bewirkt und es erleichtert, bei der Herstellung des Moduls eine ebene Bodenplatte 6 zu erreichen. Außerdem können durch deu mehrschichtigen Aufbau des Substrats 5 sogenannte Bandleitungen oder Streifenleitungen für Last- oder Ansteuerleitungen hergestellt werden, indem Stromhin- und -rückführungen in übereinanderliegenden Streifen ausgeführt werden. Damit wird eine sehr geringe Induktivität und durch geeignete Dimensionierung der Streifenbreite und der Dicke der zweiten Keramikplatte 7 ein definierter Wellenwiderstand in den Zuleitungen erreicht. Die dadurch festgelegte Leitungsgeometrie wird zweckmäßig bei der Herstellung von Außenanschlüssen beibehalten, d.h. die Anschlußelemente 12, 13 haben die gleiche Breite und den gleichen effektiven Abstand zueinander wie die strukturierten Metallisierungen 9, 11 mit zwischenliegender zweiter Keramikplatte 7.

Eine derartige Gestaltung der Leitungsführung im Modul erleichtert einem Anwender wesentlich die Ausnutzung der Schaltgeschwindigkeit von z.B. MOSFETs. Durch den als Chip-Widerstand ausgeführten Widerstand 4 in der Ansteuerleitung ist ein impedanzangepaßter Abschluß der Zuleitung möglich. Damit werden gleichzeitig parasitäre Schwingungen zwischen evtl. vielen parallelliegenden MOSFET-Gates im Modul bedämpft.

Die vorgeschlagene Schichtung mehrerer strukturierter Keramik- und Metallschichten über der Bodenplatte 6 ermöglicht auch eine hybride Integration von Ansteuerschaltungen in einem Leistungshalbleitermodul. Dabei werden in Chipform realisierte Ansteuerschaltungen in entsprechende Ausschnitte in einer Keramikschicht eingesetzt und in gleicher Weise verlötet und/oder gebondet wie die Leistungshalbleiterchips 2, 3.

Fig. 3 zeigt einen im Modul realisierten Schaltungsteil 1 in Draufsicht. Dabei sind außer den bereits oben erläuterten Bauteilen weitere Einzelheiten zu erkennen. Innerhalb der Ausschnitte 10 in der zweiten Keramikplatte 7 sind Ausnehmungen 16 und durch die zweite Keramikplatte 7 und evtl. weitere darüberliegende Schichten sind Bohrungen 17 vorgesehen. Die Bohrungen 17 sowie durch die Ausnehmungen 16 entstehende Schlitze ermöglichen es einer später einzubringenden Weichvergußmasse, die der elektrischen Isolierung dient, zwischen die strukturierten Metallisierungsflächen 9, 11 zu kriechen.

Die Herstellung der Ausschnitte 10 mit Ausnehmungen 16 sowie der Bohrungen 17 erfolgt an sogenannten grünen, d.h. noch nicht gesinterten Keramikplatten. Die Struktur der Kupferschichten entsteht entweder durch entsprechendes Stanzen der Kupferfolien vor dem Verbinden mit der Keramik oder, soweit die Kupferschichten dann noch zugänglich sind, durch Ätzen des Kupfers nach dem Verbinden mit der Keramik.

Das fertig bestückte Substrat 5 kann nach Herstellung der Löt- und Bondverbindungen in bekannter Weise in ein hauben- oder rahmenförmiges Kunststoffgehäuse eingesetzt werden, wobei das Substrat 5 den Modulboden bildet. Die ganzflächige Metallisierung 8 auf der Unterseite des Moduls ist als vorteilhafte Ausgestaltung anzusehen, jedoch nicht unbedingt erforderlich. Sie sorgt für einen guten Wärmekontakt und kann z.B. geringfügige Rauhigkeiten der Kühlkörperoberfläche ausgleichen, so daß das Modul ohne Wärmeleitpaste montiert werden kann. Durch eine obere Öffnung im Kunststoffgehäuse kann das Modul mit Weichvergußmasse bis zu einem gewünschten Füllstand gefüllt werden. Die Anschlußelemente 12, 13 werden durch entsprechende Öffnungen im Kunststoffgehäuse geführt, wodurch der vorgesehene Abstand zueinander sichergestellt wird. In den Anschlußelementen 12, 13 vorgesehene Dehnungsbogen 18 entlasten das Substrat 5 von mechanischen Belastungen, die von äußeren Anschlüssen ausgehen können.

**Ansprüche**

1. Leistungshalbleitermodul mit einer Leistungshalbleiterchips (2,3) tragenden keramischen Bodenplatte (6) und mindestens einer weiteren, parallel zur Bodenplatte (6) und uber ihr angeordneten Keramikplatte (7), wobei sowohl die Bodenplatte (6) als auch die mindestens eine weitere Keramikplatte (7) auf mindestens einer Seite eine Metallisierung (8.9,11) trägt, welche, soweit sie der Stromhin- und -rückführung dient, zu Leiterbahnen strukturiert ist, dadurch gekennzeichnet,

daß die Keramikplatten und die Metallisierungen in abwechselnder Folge zu einem mehrschichtigen Substrat (5) verbunden sind, in dem die mindestens eine weitere Keramikplatte (7) mit Ausschnitten (10) versehen ist, in die die Leistungshalbleiterchips (2,3) eingesetzt und dabei wie von einer Lötform fixiert sind, in dem die Metallisierungen aus einer 0,1 bis 0,5 mm dicken Metallfolie bestehen und derart angeordnet sind, daß sich zwischen der Bodenplatte (6) und der mindestens einen weiteren Keramikplatte (7) eine erste strukturierte Metallisierung (9) und auf der Oberseite der mindestens einen weiteren Keramikplatte (7) eine zweite strukturierte Metallisierung (11) befindet, und in dem die erste und die zweite strukturierte Metallisierung (9,11) in übereinanderliegenden Streifen derart ausgeführt sind, daß interne Streifenleitungen gebildet sind, deren Wellenwiderstand durch die Streifenbreite und durch ihren der Dicke der mindestens einen weiteren Keramikplatte (7) entsprechenden Abstand bestimmt ist.

2. Leistungshalbleitermodul nach Anspruch 1, dadurch gekennzeichnet, daß die Bodenplatte (6) auch auf der unteren, einem Kühlkörper zugewandten Seite mit einer Metallisierung (8) versehen ist.

3. Leistungshalbleitermodul nach Anspruch 1 oder 2, dadurch gekennzeichnet, daß Anschlußelemente (12,13) für äußere Modulanschlüsse mit der Breite und dem Abstand der internen Streifenleitungen angeordnet sind, um den definierten Wellenwiderstand der internen Streifenleitungen bis zum äußeren Anschluß fortzusetzen.

4. Leistungshalbleitermodul nach einem der vorstehenden Ansprüche, dadurch gekennzeichnet, daß bei Verwendung steuerbarer Leistungshalbleiterchips (2,3) zusätzliche Ausschnitte in der mindestens einen weiteren Keramikplatte (7) vorgesehen sind, in die Ansteuerschaltungen für die steuerbaren Leistungshalbleiterchips (2,3) eingesetzt sind.

5. Leistungshalbleitermodul nach einem der vorstehenden Ansprüche, dadurch gekennzeichnet, daß das Modul in ein hauben- oder rahmenförmiges Kunststoffgehäuse eingesetzt ist.

6. Leistungshalbleitermodul nach einem der vorstehenden Ansprüche, dadurch gekennzeichnet, daß die mindestens eine weitere Keramikplatte (7) und die zweite strukturierte Metallisierung (11) mit Bohrungen (17) und mit im Bereich der Ausschnitte (10) gebildeten Ausnehmungen (16) zur Aufnahme einer Weichvergußmasse versehen sind.

7. Leistungshalbleitermodul nach einem der vorstehenden Ansprüche, dadurch gekennzeichnet, daß in der einen weitereu Keramikplatte (7) zusätzliche Ausschnitte zur Aufnahme weiterer Bestuckungselemente, wie Widerstände (4), Clips (14) oder Anschlußelemente (12,13) vorhanden sind.

## Claims

1. Power semiconductor module having a ceramic base plate (6) carrying power semiconductor chips (2, 3), and at least one further ceramic plate (7) arranged parallel to the base plate (6) and above it, both the base plate (6) and the at least one further ceramic plate (7) carrying a metallic coating (8, 9, 11) on at least one side, which metallic coating is structured, to the extent that it serves to conduct current outwards and inwards, to form printed conductors, characterized in that
the ceramic plates and the metallic coatings are connected in alternating sequence to form a multilayer substrate (5),
in which the at least one further ceramic plate (7) is provided with cutouts (10) into which the power semiconductor chips (2, 3) are inserted and fixed in the process such as by a soldering form,
in which the metallic coatings consist of a metallic foil 0.1 to 0.5 mm thick and are arranged such that a first structured metallic coating (9) is situated between the base plate (6) and the at least one further ceramic plate (7) and a second structured metallic coating (11) is situated on the top side of the at least one further ceramic plate (7),
and in which the first and the second structured metallic coating (9, 11) are embodied in strips one above another in such a way that internal striplines are formed whose wave impedance is determined by the strip width and by their spacing, which corresponds to the thickness of the at least one further ceramic plate (7).

2. Power semiconductor module according to Claim 1, characterized in that on the lower side facing a heat sink the base plate (6) is also provided with a metallic coating (8).

3. Power semiconductor module according to Claim 1 or 2, characterized in that terminal elements (12, 13) for external module terminals are arranged with the width and the spacing of the internal striplines, in order to continue the defined wave impedance of the internal striplines up to the external terminal.

4. Power semiconductor module according to one of the preceding claims, characterized in that when controllable power semiconductor chips (2, 3) are used, additional cutouts, into which control circuits for the controllable power semiconductor chips (2, 3) are inserted, are provided in the at least one further ceramic plate (7).

5. Power semiconductor module according to one of the preceding claims, characterized in that the module is inserted into a hood-shaped or frame-shaped plastic package.

6. Power semiconductor module according to one of the preceding claims, characterized in that the at least one further ceramic plate (7) and the second structured metallic coating (11) are provided with bores (17) and with recesses (16), the latter formed in the region of the cutouts (10), for accommodating a soft sealing compound.

7. Power semiconductor module according to one of the preceding claims, characterized in that additional cutouts are present in the at least one further ceramic plate (7) in order to accommodate further fitted elements, such as resistors (4), clips (14) or terminal elements (12, 13).

## Revendications

1. Module semi-conducteur de puissance comprenant une plaque support céramique (6), portant des pastilles seni-conductrices de puissance (2, 3), et au moins une plaque céramique (7) supplémentaire, parallèle à la plaque support (6) et disposée audessus de celle-ci, aussi bien la plaque support (6) qu'au moins une plaque céramique (7) supplémentaire portant sur au moins une face une métallisation (8, 9, 11) qui est structurée sous forme de pistes conductrices dans la mesure où elle sert à l'aller et au retour du courant, caractérisé par le fait que les plaques céramiques et les métallisations se succèdent en alternance pour former un substrat (5) en plusieurs couches, dans lequel au moins une plaque céramique (7) supplémentaire est pourvue de découpes (10) dans lesquelles les pastilles semiconductrices de puissance (2, 3) sont insérées et fixées comme par une forme de soudage, dans lequel les métallisations sont constituées par une feuille métallique d'une épaisseur allant de 0,1 à 0,5 mm et sont disposées de telle manière qu'une première métallisation structurée (9) se trouve entre la plaque support (6) et au moins une plaque céramique (7) supplémentaire et une deuxième métallisation structurée (11) se trouve sur la face supérieure d'au moins une plaque céramique (7) supplémentaire, et dans lequel la première et la deuxième métallisation structurée (9, 11) sont des rubans superposés de manière à former des guides d'ondes à ruban internes dont l'impédance caractéristique est déterminée par la largeur des rubans et par leur distance correspondant à l'épaisseur d'au moins une plaque céramique (7) supplémentaire.

2. Module selon la revendication 1, caractérisé par le fait que la plaque support (6) est pourvue d'une métallisation (8) aussi sur sa face inférieure, tournée vers un refroidisseur.

3. Module selon la revendication 1 ou 2, caractérisé par le fait que des éléments de connexion (12, 13) sont prévus pour les connexions de module extérieures ayant la largeur et la distance des guides d'ondes à ruban internes, afin de maintenir l'impédance caractéristique définie des guides d'onde à ruban internes jusqu'à la connexion extérieure.

4. Module selon l'une des revendications précédentes, caractérisé par le fait que, en cas d'utilisation de pastilles semiconductrices de puissance (2, 3) commandables, des découpes supplémentaires sont prévues dans au moins une plaque céramique (7) supplémentaire, découpes dans lesquelles sont insérés des circuits de commande pour les pastilles semiconductrices de puissance (2, 3) commandables.

5. Module selon l'une des revendications précédentes, caractérisé par le fait que le module est inséré dans un boîtier en matière plastique en forme de coiffe ou de cadre.

6. Module selon l'une des revendications précédentes, caractérisé par le fait qu'au moins une plaque céramique (7) supplémentaire et la deuxième métallisation structurée (11) sont pourvues de trous (17) et d'évidements (16) qui sont formés dans la zone des découpes (10) en vue de recevoir une masse de scellement tendre.

7. Module selon l'une des revendications précédentes, caractérisé par le fait que dans au moins une plaque céramique (7) supplémentaire des découpes supplémentaires sont prévues pour recevoir des éléments d'équipement supplémentaires, tels que des résistances (4), des clips (14) ou des éléments de connexion (12, 13).

Fig_1

Fig_2

Fig 3